(19) **Europäisches Patentamt / European Patent Office / Office européen des brevets**

(11) **EP 2 890 992 B1**

(12) **FASCICULE DE BREVET EUROPEEN**

(45) Date de publication et mention
de la délivrance du brevet:
**21.09.2016 Bulletin 2016/38**

(51) Int Cl.:
***G01R 33/028*** (2006.01)    ***G01R 33/038*** (2006.01)

(21) Numéro de dépôt: **13756434.0**

(22) Date de dépôt: **29.08.2013**

(86) Numéro de dépôt international:
**PCT/EP2013/067857**

(87) Numéro de publication internationale:
**WO 2014/033194 (06.03.2014 Gazette 2014/10)**

(54) **DISPOSITIF DE MESURE DE CHAMP MAGNETIQUE A FORCE DE LAPLACE**

VORRICHTUNG ZUR MESSUNG VON MAGNETFELDERN MIT LAPLACE-KRAFT

DEVICE FOR MEASURING MAGNETIC FIELDS WITH LAPLACE FORCE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.08.2012 FR 1258056**

(43) Date de publication de la demande:
**08.07.2015 Bulletin 2015/28**

(73) Titulaire: **Commissariat à l'Energie Atomique et aux Energies Alternatives
75015 Paris (FR)**

(72) Inventeurs:
• **ROBERT, Philippe**
  **F-38000 Grenoble (FR)**
• **ETTELT, Dirk**
  **45892 Gelsenkirchen (DE)**
• **WALTHER, Arnaud**
  **F-38000 Grenoble (FR)**

(74) Mandataire: **GIE Innovation Competence Group
310, avenue Berthelot
69372 Lyon Cedex 08 (FR)**

(56) Documents cités:
**US-A1- 2006 076 947     US-A1- 2011 304 325
US-B1- 7 642 692**

**Description**

L'invention concerne un dispositif de mesure de champ magnétique à force de Laplace.

La force de Laplace est également connue sous le terme anglais de « Lorentz force ».

Les dispositifs de mesure de champ magnétique à force de Laplace peuvent être utilisés pour mesurer une composante du champ magnétique terrestre ou une composante d'un champ magnétique généré par un conducteur électrique ou une autre source de champ magnétique.

Par composante du champ magnétique, on désigne l'amplitude de la projection orthogonale du champ magnétique sur un axe de mesure du dispositif de mesure.

Des dispositifs connus de mesure comportent :

- un substrat s'étendant essentiellement dans un plan appelé « plan du substrat »,
- un premier cadre rigide s'étendant essentiellement dans un plan appelé « plan du premier cadre » et suspendu au-dessus du substrat, ce premier cadre étant déplaçable par rapport au substrat en rotation autour d'un premier axe de rotation parallèle au plan du substrat,
- un conducteur électrique fixé sans aucun degré de liberté sur le premier cadre rigide, ce conducteur étant enroulé autour d'un axe d'enroulement perpendiculaire au plan du premier cadre,
- au moins une première charnière raccordant mécaniquement le cadre rigide au substrat, et
- au moins un premier capteur de contrainte apte à mesurer une grandeur physique représentative de l'amplitude du débattement angulaire du premier cadre rigide autour de son axe de rotation.

Par exemple, de un tel dispositif de mesure est décrit dans l'article A1 suivant :

- A.L. Herrera-May et al, « A resonant magnetic field microsensor with high quality factor at atmospheric pressure », J. Micromechanical Microengineering, 19 (2009) 015016.

Le dispositif de mesure de A1 fonctionne correctement. Il est cependant souhaitable d'améliorer sa sensibilité.

De l'état de la technique est également connu de :

- US2011/304325A1,
- US 7 642 692B1,
- US2006/076947A1.

Jusqu'à présent la connexion du conducteur électrique fixé sur le premier cadre rigide s'est avérée difficile à fabriquer. A cause de ces difficultés, les dispositifs connus de mesure de champ magnétique à force de Laplace adoptent une conformation particulière qui limite le nombre de spires du conducteur électrique à moins d'une seule spire. Il est toutefois souhaitable de disposer d'une conformation du dispositif de mesure qui ne limite pas le nombre de spires du conducteur électrique.

Elle a donc pour objet un dispositif de mesure de champ magnétique à force de Laplace conforme à la revendication 1.

Dans le dispositif ci-dessus, à cause de la position particulière des charnières et, en particulier parce que la première charnière est placée à l'intérieur de l'évidement central et la seconde charnière à l'extérieur, le raccordement des extrémités du conducteur électrique aux plots de connexion ne pose aucun problème même si ce conducteur s'enroule plusieurs fois autour de l'axe d'enroulement. De plus, cette disposition particulière des charnières est simple à réaliser par les techniques de fabrications des puces microélectroniques.

Dans un mode de réalisation particulier, le dispositif de mesure comporte les caractéristiques de la revendication 2.

Dans ce cas, la poutre du capteur est directement fixée, d'un côté, sur le premier cadre rigide et, d'un autre côté, sur le substrat. Dans ces conditions, le cadre rigide forme un levier qui amplifie d'autant plus la force de Laplace exercée que la première extrémité de la poutre est proche de l'axe de rotation. Ici, la première extrémité de la poutre est beaucoup plus proche de l'axe de rotation que l'emplacement où s'applique la force de Laplace sur le premier cadre. Ainsi, cette conformation particulière du dispositif de mesure permet d'amplifier par un facteur d'au moins deux la force de Laplace mesurée par le capteur et donc d'augmenter sa sensibilité de ce dispositif de mesure par rapport à celui décrit dans A1.

En effet, dans le cas du dispositif de mesure de A1, les capteurs de contrainte sont intégrés sur des lamelles flexibles latérales permettant au cadre de pivoter autour de son axe de rotation. Dans ces conditions pour que les capteurs puissent mesurer une variation de contrainte, il faut que ces lamelles soient déformables. Dans le cas contraire, les capteurs ne mesureraient aucun signaux. Dès lors, puisque chaque lamelle est déformable on ne profite pas directement d'un effet mécanique de bras de levier dans le cas du dispositif de mesure de A1. Cela explique pourquoi le dispositif de mesure de A1 est moins sensible que celui décrit ci-dessus.

De plus, du fait que le capteur est mécaniquement séparé du cadre et de la charnière, il est plus facile d'optimiser les dimensions du dispositif de mesure ci-dessus. Par exemple, chaque élément peut être dimensionné individuellement pour atteindre une fréquence de résonance mécanique donnée pour le dispositif de mesure. Ici, les modifications des dimensions de l'un de ces éléments n'entraînent pas nécessairement la modification des dimensions des autres éléments. A l'inverse, la fréquence de résonance mécanique du dispositif de mesure de A1 est difficile à ajuster. En effet, dans le dispositif de mesure de A1 les différents paramètres sur lesquels on peut jouer pour obtenir une fréquence de résonance souhaitée du cadre sont intimement liés à la sensibilité du dispositif de mesure. Par exemple, il n'est pas possible de modifier la raideur des charnières sans modifier la sensibilité du dispositif de mesure. En effet, les capteurs utilisés pour mesurer le débattement angulaire du cadre sont directement fixés sur les lamelles flexibles latérales. Ainsi, accroître la raideur de ces lamelles conduit à limiter la sensibilité du dispositif de mesure de A1.

Les modes de réalisation de ce dispositif de mesure peuvent aussi comporter une ou plusieurs des caractéristiques des autres revendications dépendantes.

Ces modes de réalisation du dispositif de mesure présentent en outre les avantages suivants :

-    placer le centre de gravité du cadre dans un plan perpendiculaire au plan du cadre et contenant son axe de rotation rend le dispositif de mesure peu sensible aux accélérations perpendiculaires au plan du substrat ;

-    utiliser une branche latérale et une poutre suspendue, parallèle au plan du substrat, dont l'extrémité est raccordée à cette branche latérale augmente la sensibilité du dispositif de mesure car dans cette conformation la poutre travaille essentiellement en traction-compression et quasiment pas en flexion ;

-    utiliser une encoche dans la branche latérale pour rapprocher la première extrémité de la poutre de l'axe de rotation permet de limiter encore plus le travail en flexion de la poutre ;

-    utiliser deux exemplaires de la première charnière raccordés mécaniquement à des bras différents du premier cadre permet de diminuer la sensibilité du dispositif de mesure vis-à-vis des accélérations perpendiculaires au plan du substrat ;

-    utiliser une piste électrique qui passe sous le cadre rigide pour relier électriquement le conducteur électrique à un plot de connexion situé à l'extérieur du cadre facilite le raccordement électrique du conducteur et donc la fabrication du dispositif de mesure ;

-    utiliser un second cadre rigide monté en rotation selon un axe de rotation différent du premier axe de rotation et supportant le premier cadre rigide permet de mesurer deux composantes différentes du champ magnétique tout en utilisant le même conducteur électrique, ce qui permet, par exemple, de décroître la consommation électrique du dispositif de mesure ;

-    utiliser une barre de torsion pour réaliser la charnière permet simplement d'obtenir une charnière souple en torsion autour de l'axe de rotation et rigide en flexion selon les axes perpendiculaires à cet axe de rotation ;

-    utiliser un conducteur électrique qui s'enroule plusieurs fois autour de l'axe d'enroulement permet d'accroître encore plus la sensibilité du dispositif de mesure.

L'invention sera mieux comprise à la lecture de la description qui va suivre, donnée uniquement à titre d'exemple non limitatif et faite en se référant aux dessins sur lesquels :

-    la figure 1 est une illustration schématique, en vue de dessus, d'un premier mode de réalisation d'un dispositif de mesure de champ magnétique à force de Laplace;

-    la figure 2 est une illustration schématique, en vue de profil, du dispositif de mesure de la figure 1 ;

-    les figures 3 à 9 sont des illustrations schématiques de différentes étapes de fabrication du dispositif de mesure de la figure 1 ;

-    les figures 10, 12, 20 et 21 sont des illustrations schématiques, en vue de dessus, de différents autres modes de réalisation possibles d'un dispositif de mesure à force de Laplace ;

-    la figure 11 est une illustration schématique d'un capteur à jauge résonante utilisé dans le mode de réalisation de la figure 10 ;

-    les figures 13 à 19 sont des illustrations schématiques de différentes étapes de fabrication du dispositif de mesure de la figure 12.

Dans ces figures, les mêmes références sont utilisées pour désigner les mêmes éléments. Dans la suite de cette description, les caractéristiques et fonctions bien connues de l'homme du métier ne sont pas décrites en détail.

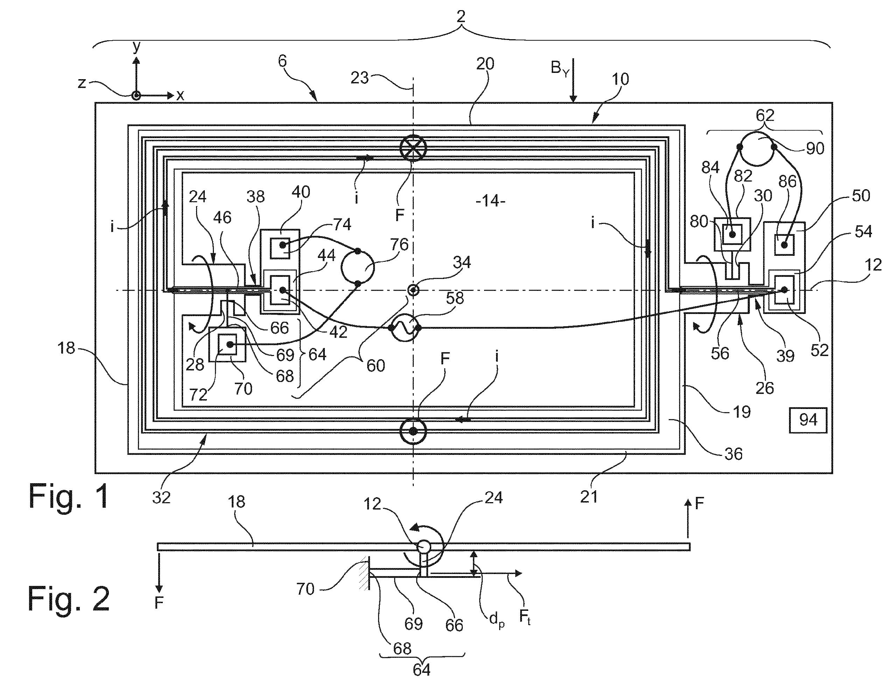

La figure 1 représente un dispositif 2 de mesure de champ magnétique à force de Laplace. Plus précisément, ce dispositif 2 est apte à mesurer l'amplitude d'une composante $B_Y$ du champ magnétique. La composante $B_Y$ est représentée par une flèche. La composante $B_Y$ est parallèle au plan de la feuille et parallèle à un axe Y d'un repère orthogonal X, Y, Z. Les axes X et Y sont horizontaux et l'axe Z est vertical. Dans la suite de cette description, les termes « au-dessus », « au-dessous », « supérieur » et « inférieur » sont définis par rapport à la direction Z.

Le dispositif 2 comporte un substrat 6 qui s'étend essentiellement dans un plan horizontal appelé « Plan du substrat ». Typiquement, les dimensions de ce substrat 6 sont inférieures à 1 mm². Par exemple, sa longueur est inférieure à 1 mm ou 500 $\mu$m, et sa largeur est inférieure à 500 $\mu$m ou 300 $\mu$m.

Le substrat 6 est réalisé dans un matériau usinable par les techniques de la microélectronique, c'est-à-dire les mêmes techniques que celles utilisées pour réaliser des composants électroniques tels que des transistors. Par exemple, le substrat 6 est un substrat semiconducteur tel que du Silicium.

Le dispositif comporte un cadre rigide 10 suspendu au-dessus du substrat 6. Ici, par suspendu, on désigne un élément mécaniquement isolé du substrat 6, dans la direction Z, par un évidement dans lequel on fait le vide ou qui est rempli d'un gaz. L'élément est alors apte à se déplacer par rapport au substrat 6. Ici, le cadre 10 est apte à se déplacer en rotation autour d'un axe 12 de rotation. L'axe 12 est parallèle à la direction X.

Le cadre 10 s'étend essentiellement dans un plan, appelé plan du cadre. Ici, le cadre 10 a une forme essentiellement rectangulaire.

Le cadre 10 comprend un évidement central traversant 14. De part et d'autre de l'évidement 14, dans la direction X, le cadre 10 comporte des bras rigides 18 et 19. De même, de part et d'autre de l'évidement 14, dans la direction Y, le cadre 10 comporte des jambes rigides 20 et 21. Les bras 18 et 19 sont parallèles à la direction Y, tandis que les jambes 20 et 21 sont parallèles à la direction X. Les extrémités des jambes 20 et 21 sont fixées, sans aucun degré de liberté, d'un côté, au bras 18 et, de l'autre côté, au bras 19.

Ici, le bras 19 est le symétrique du bras 18 par rapport à un plan vertical 23. Ainsi, seul le bras 18 est décrit plus en détail.

La longueur $Lo_{18}$ du bras 18 dans la direction Y est typiquement inférieure à 2 mm ou à 500 $\mu$m et, de préférence, supérieure à 50 ou 100 $\mu$m. La largeur $La_{18}$ du bras 18 dans la direction X est inférieure à $Lo_{18}/2$ ou à $Lo_{18}/5$. L'épaisseur du bras 18 est égale à l'épaisseur $e_{CR}$ du cadre 10. L'épaisseur $e_{CR}$ est l'épaisseur moyenne du cadre 10 dans la direction Z. Par exemple, cette épaisseur est strictement inférieure à la largeur $La_{18}/2$. Ici, l'épaisseur $e_{CR}$ est inférieure à 10 ou 30 $\mu$m et, de préférence, supérieure à 2 ou 5 $\mu$m.

La jambe 21 est le symétrique de la jambe 20 par rapport à un plan vertical passant par l'axe 12. Ce plan vertical est aussi un plan de symétrie pour les bras 18 et 19. La longueur $Lo_{20}$ de la jambe 20, dans la direction X, est typiquement inférieure à 2 millimètres ou 500 $\mu$m. Cette longueur $Lo_{20}$ est également, de préférence, supérieure à 50 ou 100 $\mu$m. La largeur $La_{20}$ de la jambe 20, dans la direction Y, est inférieure à $Lo_{20}/2$ ou à $Lo_{20}/5$. L'épaisseur de la jambe 20 est égale à l'épaisseur $e_{CR}$ du cadre 10.

Le cadre 10 est réalisé dans des matériaux rigides, c'est-à-dire des matériaux dont le module de Young à 25° Celsius est supérieur à 20 GPa ou 50 GPa ou 100 GPa. Par exemple, le cadre 10 est réalisé dans un matériau semi-conducteur tel que le silicium.

Le cadre 10 comporte également deux branches latérales rigides 24 et 26. Ces branches 24 et 26 forment des saillies latérales depuis, respectivement, les bras 18 et 19. La branche 24 s'étend le long de l'axe 12 depuis le bras 18 vers l'intérieur de l'évidement 14. La branche 26 s'étend le long de l'axe 12 depuis le bras 19 en s'éloignant vers l'extérieur du cadre 10. Ici, les branches 24 et 26 ne forment qu'un seul bloc de matière avec, respectivement, les bras 18 et 19.

La largeur $La_{24}$ de la branche 24, dans la direction Y, est ici égale à la largeur $La_{18}$ du bras 18. La longueur $Lo_{24}$ de la branche 24, dans la direction X, est inférieure ou égale à $Lo_{20}/2$ ou à $Lo_{20}/3$. L'épaisseur de la branche 24 est égale à l'épaisseur $e_{CR}$ du cadre 10.

Cette branche 24 est donc traversée de part-en-part par l'axe 12.

La branche 24 comporte une encoche 28 creusée dans la direction Y. Cette encoche 28 se termine par un fond vertical parallèle à l'axe 12 et situé à proximité de cet axe 12. Ici, la distance la plus courte entre ce fond vertical et l'axe 12 est inférieure à la largeur $La_{24}/3$ et, de préférence, inférieure à $La_{24}/5$ ou $La_{24}/10$. Par exemple, la distance la plus courte est inférieure à 5 ou 10 $\mu$m. Avantageusement, cette distance est nulle. Ici, l'encoche 28 est entièrement située d'un seul côté du plan vertical passant par l'axe 12.

La branche 26 est identique à la branche 24 sauf que l'encoche 28 est remplacée par une encoche 30. L'encoche 30 est identique à l'encoche 28 mais entièrement située de l'autre côté du plan vertical passant par l'axe 12.

Grâce à l'agencement précédemment décrit du cadre 10, le centre de gravité de ce cadre est situé à proximité de l'axe 12 de sorte qu'il est très peu sensible aux accélérations dans les directions X, Y et Z. Ici, par « situé à proximité », on désigne le fait que la distance la plus courte entre ce centre de gravité du cadre 10 et l'axe 12 est :

- inférieure à la longueur $Lo_{18}/50$ dans la direction Y, et
- inférieure à l'épaisseur $e_{CR}$ ou $e_{CR}/2$ dans la direction Z.

Le cadre 10 est dit « rigide ». Ici par « rigide », on désigne le fait que sa section transversale et le matériau dans lequel il est réalisé ont été choisis de manière à ce que sa raideur en flexion, au niveau d'un point de la jambe 20 ou 21 où s'applique la force de Laplace à mesurer, dans la direction d'application de cette force de Laplace, est au moins deux fois supérieure et, de préférence au moins dix ou cent fois supérieure, à la raideur en compression de la ou des poutres suspendues qui rattachent également ce cadre au substrat 6. Ces poutres suspendues sont décrites plus loin. La raideur en flexion est par exemple mesurée ou calculée en remplaçant la ou les barres de torsion par un ancrage correspondant de raideur infinie et ne présentant aucun degré de liberté. Les barres de torsion sont décrites plus loin. Pour le cadre 10, la direction d'application de la force de Laplace est parallèle à la direction Z.

Le dispositif 2 comprend également un conducteur électrique 32 déposé, sans aucun degré de liberté, sur la face supérieure du cadre 10. Ce conducteur 32 s'enroule autour d'un axe 34 vertical perpendiculaire au plan du cadre 10 et coupant l'axe 12. Ici, l'axe 34 est sensiblement au centre de l'évidement rectangulaire 14. Sur la figure 1, cet axe 34 est représenté par un point au milieu d'un cercle.

Le conducteur 32 fait plusieurs tours complets autour de l'axe 34. Il forme donc une bobine comportant plusieurs spires complètes. Il est isolé du cadre 10 par une couche 36 en matériau électriquement isolant. Sur chaque jambe 20, 21, le conducteur 32 forme des segments rectilignes parallèles à la direction X. Par conséquent, quand le conducteur 32 est parcouru par un courant en présence de la composante $B_Y$ du champ magnétique, ces segments sont soumis à une force de Laplace F. Typiquement, la force de Laplace qui s'exerce sur chacun des segments du conducteur 32 est donnée par la relation suivante : $\vec{F} = \vec{idl} \wedge \vec{B_Y}$ , où :

- F est la force de Laplace qui s'exerce sur chacun des segments rectilignes du conducteur 32,
- i est l'intensité du courant qui circule dans le conducteur 32,
- dl est la longueur du segment du conducteur 32,
- By est la composante du champ magnétique à mesurer, et
- le symbole « $\wedge$ » est l'opération mathématique produit vectoriel.

Sur la figure 1, le sens de circulation du courant dans le conducteur 32 est représenté par des flèches i. Avec ce sens de circulation, la force de Laplace s'exerce perpendiculairement au plan du substrat dans un sens sur la jambe 20 et dans le sens opposé sur la jambe 21. Ainsi, la force de Laplace fait tourner le cadre 10 autour de son axe 12 de rotation. Par conséquent, le débattement angulaire du cadre 10 représente l'intensité de la force de Laplace et donc de la composante $B_y$ du champ magnétique à mesurer.

Pour permettre cette rotation du cadre 10 autour de l'axe 12, le cadre 10 est directement mécaniquement raccordé au substrat 6 par des charnières. Ces charnières sont ici des barres de torsion 38 et 39. Dans les modes de réalisation représentés sur les figures, chaque charnière est constituée par une barre de torsion.

La barre 38 est suspendue au-dessus du substrat 6. Elle s'étend le long de l'axe 12 depuis l'extrémité distale de la branche 24 jusqu'à une saillie 40 d'ancrage. La saillie 40 est fixée sans aucun degré de liberté sur le substrat 6.

Dans cette description, une barre de torsion désigne une barre conformée pour se déformer essentiellement en torsion autour d'un axe de rotation lors de l'utilisation du dispositif 2. Par exemple, dans le cas de la barre 38, l'axe de rotation est l'axe 12. Pour cela, la barre 38 est conformée de manière à ce que sa raideur en flexion dans les directions orthogonales à l'axe de rotation soit au moins cinq ou dix fois supérieure à sa raideur en torsion mesurée ou calculée au même point. Par exemple, pour cela, la largeur $La_{38}$ de la barre 38, dans la direction Y, est au moins deux ou cinq fois inférieure à la largeur $La_{24}$ de la branche 24. De préférence, l'épaisseur $e_{38}$ de la barre 38 est égale à l'épaisseur $e_{CR}$ pour faciliter le passage d'une piste électrique.

Dans ce mode de réalisation, la barre 38 raccorde également électriquement l'une des extrémités du conducteur 32 à un plot fixe 42 de connexion électrique. Ici, le plot 42 est situé sur une extrémité supérieure de la saillie 40 et isolé électriquement de cette saillie par une couche 44 en matériau électriquement isolant. Pour remplir cette fonction, la barre 38 comporte sur sa partie supérieure une piste électrique 46 qui la traverse de part en part. Une couche isolante est disposée entre cette piste électrique 46 et la partie semi-conductrice de la barre 38.

La barre 39 s'étend le long de l'axe 12 depuis l'extrémité distale de la branche 26 jusqu'à une saillie 50 d'ancrage. Par exemple, la barre 39 est identique à la barre 38. Ici, le plot, la couche en matériau isolant et la piste conductrice correspondant, respectivement, au plot 42, à la couche 44 et à la piste 46 portent, respectivement, les références 52, 54 et 56.

Les plots 42 et 52 sont électriquement raccordés par l'intermédiaire de liaisons filaires à une source 58 de courant. Ici, la source 58 est une source de courant alternatif.

Le dispositif 2 comprend également deux capteurs de contrainte 60 et 62 pour mesurer le débattement angulaire du cadre 10 autour de l'axe 12. Dans ce mode de réalisation, les capteurs 60 et 62 sont des capteurs à jauge de contrainte. La jauge de contrainte du capteur 60 est une poutre ou un fil 64 piézorésistif suspendu pour transformer le déplacement angulaire du cadre 10 en une variation de résistance mesurable. Cette poutre 64 comporte :

- une extrémité 66 ancrée sans aucun degré de liberté dans le fond vertical de l'encoche 28,
- une extrémité 68 ancrée sans aucun degré de liberté à une aspérité 70 du substrat 6, et
- une partie centrale 69 suspendue au-dessus du substrat 6.

L'épaisseur de la poutre 64 est au moins deux, cinq ou dix fois inférieure à l'épaisseur de la branche 24 de manière à concentrer la contrainte exercée par la branche 24 à l'intérieur d'une surface réduite ce qui augmente la sensibilité du dispositif 2. Cela permet également de décroître sa raideur en traction-compression. Ici, la largeur et, éventuellement la longueur, de la poutre 64 sont, par exemple, inférieure à 10 ou 5 $\mu$m.

Par exemple, la poutre 64 est réalisée en Silicium ou en SiGe, alliage de silicium et de Germanium. Elle peut aussi être réalisée en métal. De façon plus générale, elle peut être réalisée dans tout matériau dont la sensibilité piézorésistive exprimée par le rapport (dR/R)/(dl/l) est égale ou supérieure à la sensibilité des matériaux précédemment cités, où :

- dR est la variation de résistance de la poutre 64,
- R est la résistance de la poutre 64 au repos, c'est-à-dire en absence de contrainte,
- dl est la variation de la longueur de la poutre 64 lorsqu'elle est soumise à une contrainte à mesurer,

- l et la longueur au repos de la poutre 64.

Ici, la poutre 64 s'étend parallèlement à la direction Y. L'extrémité 66 est située au-dessus ou au-dessous d'un plan horizontal passant par l'axe 12. Par exemple, ici, l'extrémité 66 est située en-dessous de ce plan horizontal (Figure 2) et la poutre 64 s'étend entièrement sous ce plan horizontal, c'est-à-dire que sa face supérieure est espacée de ce plan horizontal par une distance non nul. Sur la figure 2, seule une partie du bras 18 s'étendant sur le plan horizontal passant par l'axe 12 est représentée pour améliorer la lisibilité de cette figure.

L'extrémité 66 se trouve aussi proche que possible de l'axe 12 pour bénéficier au maximum d'un effet d'amplification et d'un effort sur la poutre en pur tension/compression issu de la force de Laplace provoqué par le bras 18. A cet effet, la distance $d_p$ (Figure 2) la plus courte entre l'extrémité 66 et l'axe 12 est inférieure à $e_{CR}/2$ et, de préférence, à $e_{CR}/3$ ou $e_{CR}/5$. Par exemple, cette distance est inférieure à 5 ou 10 µm.

Le capteur 60 comporte également deux plots électriques 72 et 74 et un ohmmètre 76. Les plots 72 et 74 sont directement électriquement raccordés, respectivement, aux extrémités 66 et 68 de la poutre 64. Ici, par directement, on désigne le fait que le raccordement ne passe pas par l'intermédiaire de la poutre 64 ou de l'ohmmètre 76.

Par ohmmètre, on entend ici tout type de dispositif capable de mesurer une variation de résistance, directement ou indirectement. En pratique, on pourra par exemple utiliser une mesure de tension à travers un pont de Wheatstone. De préférence, les capteurs 60 et 62 sont intégrés à cet effet dans un demi-pont de Wheatstone.

Le plot 74 est raccordé électriquement à l'extrémité 66 par l'intermédiaire de la barre de torsion 38.

L'ohmmètre 76 est électriquement raccordé aux plots 72 et 74 par l'intermédiaire de liaisons filaires. Cet ohmmètre 76 mesure la variation de résistance de la poutre 64 en réponse à la contrainte exercée sur elle par le levier 18 et génère un signal de mesure représentatif de la résistance mesurée.

L'autre capteur 62 est identique au capteur 60 sauf qu'il mesure un déplacement de même amplitude que le capteur 60 mais de direction opposée car sa poutre suspendue est située de l'autre côté du plan vertical passant par l'axe 12. Ici, la poutre, l'aspérité, les plots électriques et l'ohmmètre du capteur 60 correspondant à la poutre 64, à l'aspérité 70, aux plots 72, 74 et à l'ohmmètre 76 portent, respectivement, les références 80, 82, 84, 86 et 90.

Les capteurs 60 et 62 sont raccordés à une unité électronique 94 de traitement. L'unité 94 est programmée pour calculer l'amplitude de la composante $B_Y$ en fonction des signaux de mesure délivrés par les capteurs 60 et 62. Pour simplifier l'illustration, le raccordement entre l'unité 94 est les capteurs n'est pas représenté.

La fréquence $f_R$ de résonance mécanique du dispositif 2 est essentiellement fixée par le cadre 10, les barres de torsion 38, 39 et les poutres 64, 80. Ici, les dimensions du cadre 10, des barres de torsion 38, 39 et des poutres 64, 80 sont choisies pour que la fréquence $f_R$ soit supérieure à 1 kHz et, de préférence, supérieure à 10 kHz. Grâce à l'architecture du dispositif 2, il est possible de modifier les dimensions de l'un de ces éléments du dispositif pour fixer cette fréquence $f_R$ sans modifier les autres éléments ce qui facilite grandement l'optimisation mécanique du dispositif 2.

La figure 2 permet de mieux comprendre pourquoi la force de Laplace est amplifiée par l'effet levier dans le dispositif 2. La force de Laplace s'exerce à l'extrémité des bras 18 et 19 dans des directions opposées de part et d'autre de l'axe de rotation 12. Cela fait tourner la branche 24 autour de l'axe 12. Puisque l'extrémité 66 de la poutre 64 solidaire de la branche 24 est située en dessous de l'axe 12, la rotation de la branche 24 exerce, dans le cas représenté, essentiellement une force de traction $F_t$ sur la poutre 64. Par ailleurs, puisque le cadre 10 est rigide, que la barre de torsion 38 constitue un axe de rotation fixe par rapport au substrat 6 et que la distance d entre le point d'application de la force F et l'axe 12 est plusieurs fois supérieure à la distance $d_p$ entre l'extrémité 66 et l'axe 12, la force $F_t$ est plusieurs fois supérieure à la force de Laplace F à cause de l'effet levier. Ceci accroît la sensibilité du dispositif 2.

Le fonctionnement du dispositif 2 est le suivant. La source 58 génère un courant alternatif à la fréquence $f_A$ égale, avantageusement, à la fréquence de résonance $f_R$. La force de Laplace s'exerce sur le conducteur 32 tantôt dans la direction Z, tantôt dans la direction opposée. Cela excite le dispositif 2 à cette fréquence $f_A$. Le cadre 10 oscille alors autour de l'axe 12 à la fréquence $f_A$. L'amplitude angulaire de ces oscillations est représentative de la force de Laplace qui s'exerce et donc de l'amplitude de la composante $B_Y$. Les capteurs 60 et 62 génèrent des signaux de mesure représentatifs de l'amplitude du débattement angulaire du cadre 10 et transmettent ces signaux à l'unité 94. L'unité 94 calcule l'amplitude de la composante $B_Y$ du champ magnétique à partir de ces signaux.

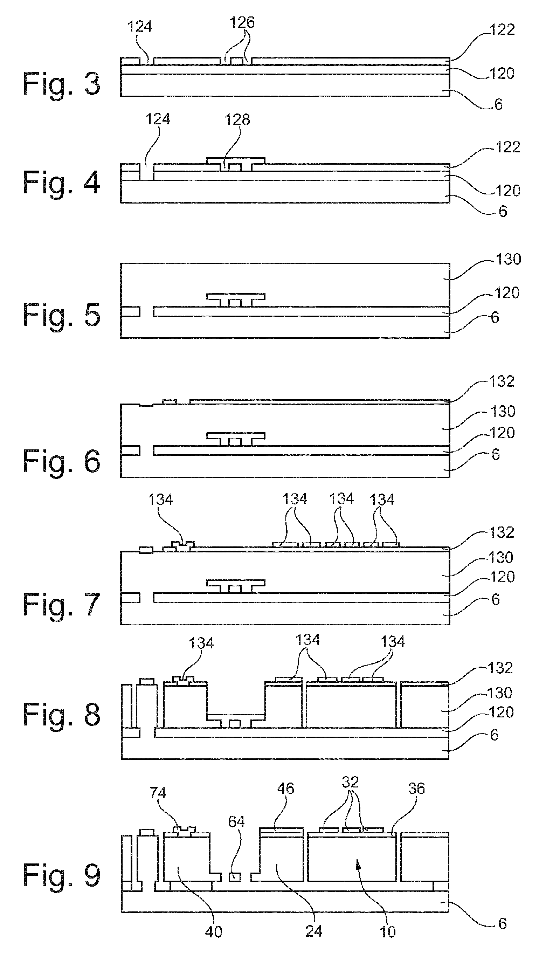

Les figures 3 à 9 représentent différentes étapes successives de fabrication du dispositif 2. Les figures 3 à 9 sont des vues en coupe verticale de différents éléments du dispositif 2. Ces différents éléments ont été juxtaposés dans ces vues, même s'ils ne sont pas l'un à côté de l'autre dans le dispositif 2. Ainsi, ces vues ne correspondent pas à une coupe du dispositif 2 selon un plan de coupe mais illustrent simplement la fabrication des différents éléments sans tenir compte de leur agencement les uns par rapport aux autres dans le dispositif 2.

La fabrication débute par la fourniture d'un substrat SOI (Silicon-On-Insulator). Ce substrat comporte le substrat 6, une couche 120 (Figure 3) en matériau électriquement isolant tel que de l'oxyde de silicium et une couche 122 (Figure 3) de silicium. Par exemple, les couches 120 et 122 ont respectivement des épaisseurs

égales à 1 μm et 0,3 μm.

Ensuite, la couche 122 est gravée par photolithographie de manière à former un trou 124 et deux trous 126 (Figure 3). Le trou 124 est utilisé pour la réalisation d'un plot de contact électrique avec le substrat 6. Les deux trous 126 sont utilisés pour la réalisation de la poutre piézorésistive 64 du capteur 60.

Ensuite, une couche d'oxyde 128 (Figure 4) est déposée sur la couche 122. Par exemple, l'épaisseur de la couche 128 est de 0,3 μm.

La couche 128 est gravée à l'aide d'un procédé photo-lithographique pour ne laisser subsister que les parties de la couche 128 qui remplissent et recouvrent les deux trous 126. Cette couche 128 est destinée à recouvrir et protéger la poutre du capteur de contrainte. Lors de ces étapes de gravure, la couche d'oxyde au fond du trou 124 est également supprimée pour laisser le substrat 6 exposé à l'extérieur.

Ensuite, une couche 130 (figure 5) de Silicium est déposée sur la couche 128. Par exemple, cette couche 130 est déposée par croissance épitaxiale sur la couche 122 et sur les restes de la couche 128. Cette couche 130 ne forme qu'une seule et même couche avec la couche 122 de sorte que seule la couche 130 a été représentée. L'épaisseur de la couche 130 est d'environ 20 μm.

Une couche 132 (figure 6) en matériau électriquement isolant est ensuite déposée sur la couche 130. Cette couche 132 est ensuite gravée par photolithographie aux emplacements où la formation d'un contact électrique direct avec la couche 130 est nécessaire. Par exemple, la couche 132 est une couche en nitrure de Silicium de 0,1 μm d'épaisseur.

Une couche 134 (figure 7) en matériau électriquement conducteur est ensuite déposée sur la couche 132. Par exemple, la couche 134 est une couche métallique. Cette couche 134 est ensuite gravée pour former les différents plots et pistes électriques du dispositif 2.

Ensuite, la couche 132 est gravée (figure 8) par photolithographie. La couche 130 est également gravée en utilisant le même masque de résine et les couches d'oxyde 120 et 128 comme couche d'arrêt. Par exemple, la couche 130 est gravée à l'aide du procédé de gravure DRIE (Deep Reactive Ion Etching).

Enfin, les couches d'oxyde 120 et 128 sont retirées (figure 9) pour libérer les différentes parties mobiles du dispositif 2. Par exemple, les couches d'oxydes sont retirées par gravure HF humide et/ou en phase vapeur.

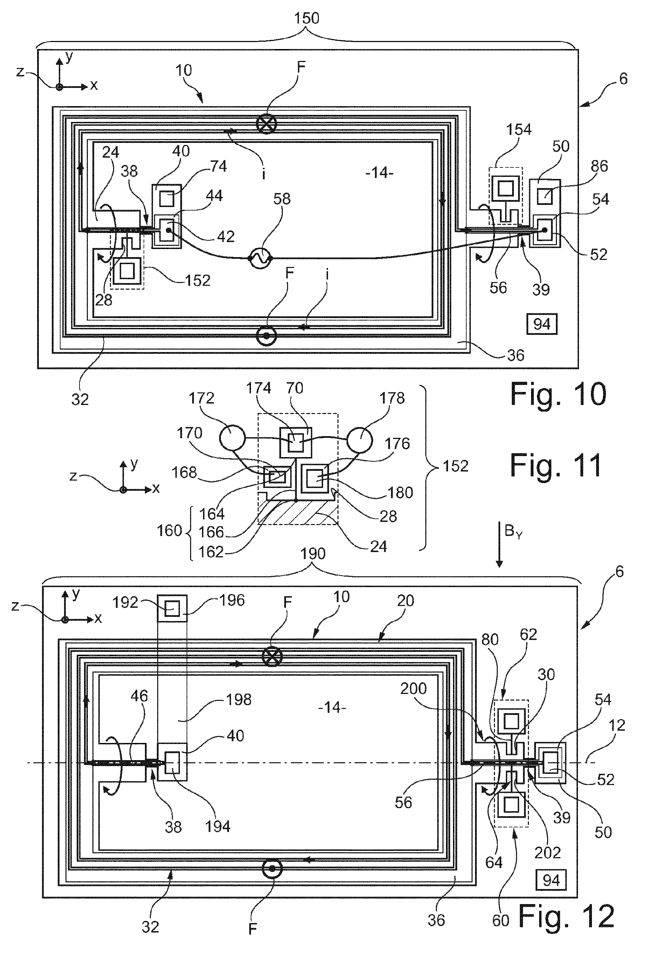

La figure 10 représente un dispositif 150 identique au dispositif 2, sauf que les capteurs 60 et 62 sont, respectivement, remplacés par des capteurs 152 et 154 de contrainte à jauges résonantes. Les capteurs 152 et 154 sont identiques sauf qu'ils mesurent chacun une contrainte de même amplitude que celle mesurée par l'autre capteur mais de signe opposé. Ainsi, seule le capteur 152 est décrit plus en détail en référence à la figure 11.

Le capteur 152 comporte une poutre 160 suspendue au-dessus du substrat 6. Une extrémité 162 de cette poutre est ancrée, sans aucun degré de liberté, dans l'axe de la poutre, à la branche 24 au fond de l'encoche 28. L'extrémité opposée 164 de cette poutre est ancrée sans aucun degré de liberté à l'aspérité 70. Une partie centrale 166 mobile de cette poutre est située entre les extrémités 162 et 164. Cette partie mobile 166 est suspendue au-dessus du substrat 6 de manière à pouvoir vibrer. Typiquement, la poutre 160 est réalisée en matériau semi-conducteur ou conducteur. Ici, elle est réalisée en Silicium. Toutefois, il n'est pas nécessaire dans ce mode de réalisation qu'elle soit réalisée en matériau piézorésistif.

Le capteur 152 comporte également une électrode d'actionnement 168 placée à proximité de la partie mobile 166 pour exercer sur cette partie mobile une force électrostatique qui l'attire de manière périodique dans la direction X. Pour faire vibrer la partie centrale, l'électrode 168 est raccordée électriquement via un plot électrique 170 à une borne d'une source 172 de tension alternative comportant une composante continue. La tension alternative est générée à une fréquence asservie sur la fréquence de résonance mécanique de la poutre 160. Pour réaliser cet asservissement, on utilise le fait que l'amplitude des vibrations de la poutre 160 est maximale lorsque la poutre vibre à sa fréquence de résonance. Une autre borne de la source 172 est directement raccordée à l'extrémité 164 de la poutre 160 par l'intermédiaire d'un plot électrique 174. Ainsi, la poutre 160 vibre à une fréquence $f_0$.

Le capteur 152 comporte également une électrode 176 de mesure disposée en vis-à-vis de la partie mobile 166 pour former avec la partie mobile un condensateur dont la capacité varie en fonction du déplacement de la partie mobile 166. L'électrode 176 est électriquement raccordée à une borne d'un capacimètre 178 par l'intermédiaire d'un plot électrique 180. L'autre borne du capacimètre 178 est raccordée au plot 174. Ainsi, le capacimètre 178 permet de mesurer l'amplitude et/ou la fréquence de vibration de la partie mobile 166. La fréquence de résonance $f_0$ varie en fonction de la contrainte exercée par la branche 24 sur la poutre 160. La valeur de la fréquence $f_0$ permet ainsi de mesurer l'amplitude du débattement angulaire de la branche 24 et donc l'amplitude de la composante $B_Y$.

La figure 12 représente un dispositif 190 identique au dispositif 2, sauf que :

- le raccordement électrique du conducteur 32 ne se fait pas par l'intermédiaire d'un plot 42 situé à l'intérieur de l'évidement 14, mais par l'intermédiaire d'un plot électrique 192 situé à l'extérieur de l'évidement 14, et
- le capteur 60 est déplacé à l'extérieur de l'évidement 14.

Le fait de déporter tous les plots de connexion électrique à l'extérieur de l'évidement 14 simplifie le raccordement électrique du dispositif 190. En effet, il n'est plus nécessaire de prévoir des fils conducteurs qui passent par-dessus le cadre 10.

Ici, le plot 42 est remplacé par un plot 194 directement en contact électrique avec la saillie 40. Pour cela, la couche d'isolant 44 entre le plot 194 et la saillie 40 est omise.

La saillie 40 est raccordée électriquement à une saillie 196 située en dehors de l'évidement 14 par l'intermédiaire d'une piste électrique 198. Cette piste 198 est fixée sans aucun degré de liberté sur le substrat 6. Ici, la piste 198 passe en dessous de la jambe 20 du cadre 10 pour rejoindre la saillie 196. La jambe 20 est donc suspendue au-dessus de la piste 198. Le plot 192 est déposé sur l'extrémité supérieure de la saillie 196.

Dans ce mode de réalisation, le capteur 60 est placé en vis-à-vis du capteur 62. Par exemple, la poutre 64 est le symétrique de la poutre 80 par rapport à un plan vertical passant par l'axe 12. A cet effet, la branche 26 est remplacée par une branche 200. La branche 200 est identique à la branche 26 sauf qu'elle comporte en plus une encoche 202 symétrique de l'encoche 30 par rapport au plan vertical contenant l'axe 12. L'extrémité de la poutre 64 est fixée au fond de l'encoche 202. Dans ces conditions, comme précédemment, le capteur 60 mesure un débattement angulaire de même amplitude que le capteur 62 mais de signe opposé.

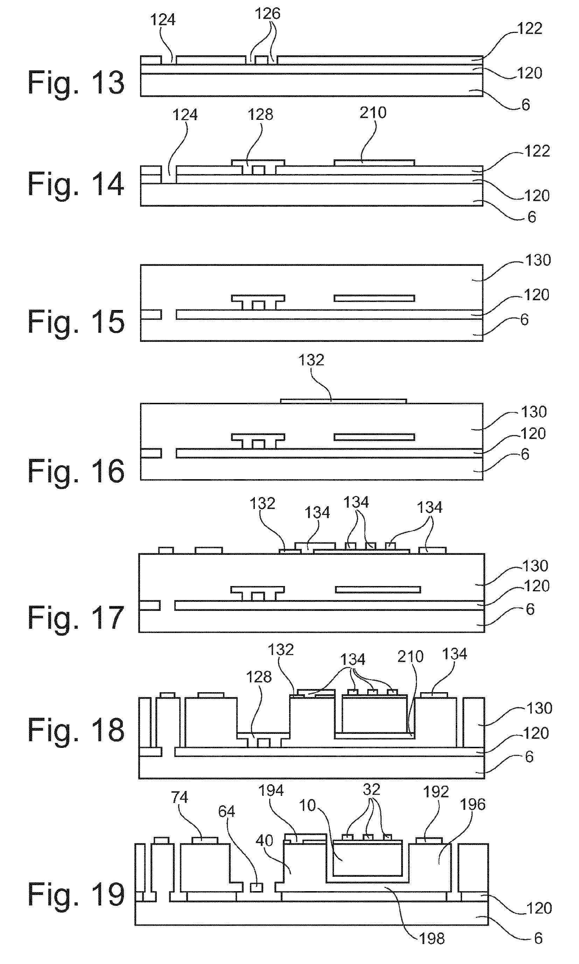

Les figures 13 à 19 représentent les différentes étapes de fabrication du dispositif 190. Ces étapes sont identiques à celles décrites en référence aux figures 3 à 9 pour tous les éléments du dispositif sauf pour la réalisation de la piste 198 et des plots 192 et 196. Plus précisément, les étapes mises en oeuvre pour obtenir les différents états de fabrication représentés successivement sur les figures 13 à 19 sont identiques à celles décrites en référence, respectivement, aux figures 3 à 9 sauf qu'un morceau supplémentaire 210 de la couche d'oxyde 128 (voir figure 14) est laissé pour préserver un morceau de la couche 122 passant sous le cadre 10. Comme représenté sur la figure 18, ce morceau 210 sert de couche d'arrêt de gravure lors de la gravure de la couche 130. Ensuite, ce morceau 210 est retiré en même temps que le reste de la couche 128 pour libérer les différentes pièces mobiles (figure 19). On obtient alors la piste 198 qui passe sous le cadre 10.

Pour former les plots 194 et 196 en contact électrique avec la piste 198, la couche de métal 134 est directement déposée sur la couche 130 puis gravée pour délimiter les plots 194 et 196 (figure 17).

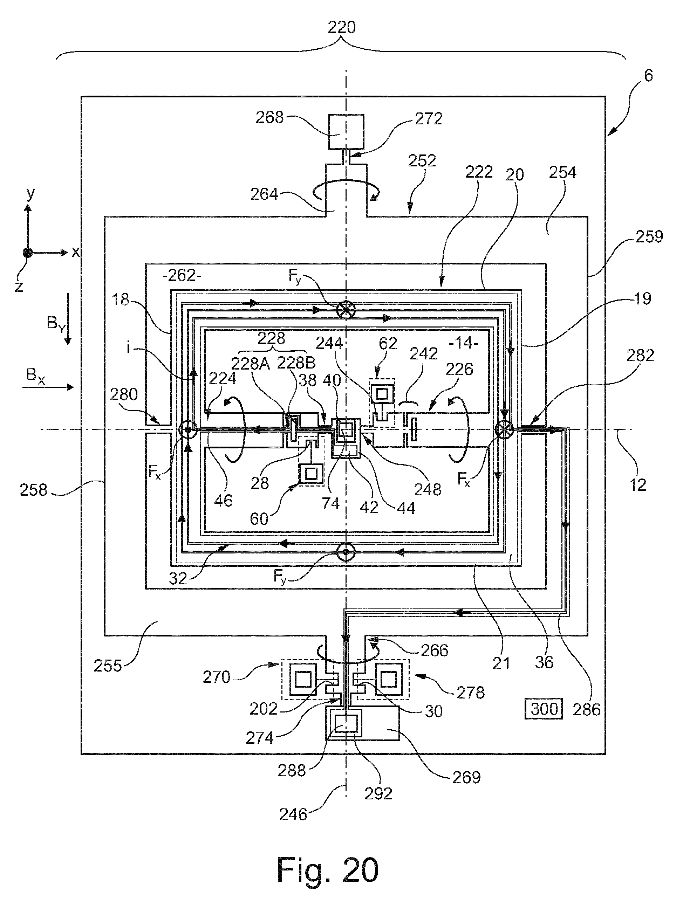

La figure 20 représente un dispositif 220 capable de mesurer à la fois les composantes $B_y$ et $B_x$ du champ magnétique tout en n'utilisant pour cela qu'un seul conducteur formant une bobine à plusieurs spires. Ce dispositif 220 comporte un cadre intérieur 222 identique au cadre 10, sauf que les branches 24 et 26 sont remplacées par, respectivement, des branches 224 et 226. Les branches 224 et 226 sont situées à l'intérieur de l'évidement 14.

La branche 224 s'étend le long de l'axe 12 de rotation du cadre 222. La branche 224 est conformée pour être rigide en torsion autour de l'axe 12 et souple en flexion dans la direction Z. A cet effet, la branche 224 est identique à la branche 24 mais comporte en plus une articulation 228 rigide en torsion et souple en flexion suivant la direction Z.

Dans ce mode de réalisation, l'articulation 228 est réalisée en combinant successivement un amincissement 228A suivi d'un évidement rectangulaire 228B. L'amincissement 228A réduit localement la largeur de la branche 224 dans la direction Y. La largeur cette amincissement 228A, dans la direction Y, est notée $La_{228A}$. L'amincissement 228A est centré sur l'axe 12 de rotation.

L'évidement 228B est un évidement rectangulaire traversant de part en part la branche 224 dans la direction Z. La largeur de cet évidement, notée $La_{228B}$, dans la direction Y est strictement supérieure à la largeur $La_{228A}$. L'amincissement 228A est plus rigide en torsion que la barre 38 de torsion. Pour cela, par exemple, sa largeur $La_{228A}$ est au moins deux fois supérieure à la largeur $La_{38}$ ou sa longueur $Lo_{228A}$ dans la direction X est au moins deux fois inférieure à la longueur $Lo_{38}$. Dans ces conditions, l'articulation 228 est beaucoup plus rigide en torsion que la barre 38. Ainsi, lors d'un déplacement en rotation de la branche 224 c'est presque exclusivement la barre 38 de torsion qui se déforme. L'articulation 228 réduit la raideur de la branche 224 à la flexion dans la direction Z. Par conséquent, cela autorise le cadre 222 à se déplacer en rotation aussi autour d'un axe horizontal 246 perpendiculaire à l'axe 12.

L'extrémité de la branche 224 est mécaniquement raccordée par l'intermédiaire de la barre 38 à la saillie 40. Comme précédemment, la saillie 40 comporte le plot 42 de connexion électrique du conducteur électrique 32 à la source 58 de courant alternatif. Sur cette figure et la suivante, la source 58 n'a pas été représentée.

La branche 226 est structurellement similaire à la branche 224 sauf qu'elle raccorde mécaniquement le bras 19 au substrat 6 et non pas le bras 18 au substrat 6. L'articulation et l'encoche de la branche 226 portent, respectivement, les références 242 et 244. Ici, la branche 226 est le symétrique de la branche 224 par rapport à un plan vertical passant par l'axe 246 à l'exception du fait que son encoche 244 est située de l'autre côté du plan vertical passant par l'axe 12.

Une barre de torsion 248 raccorde mécaniquement l'extrémité de la branche 226 à la saillie 40. La barre 248 est le symétrique de la barre 38 par rapport au plan vertical passant par l'axe 246.

La poutre 80 du capteur 62 est mécaniquement raccordée au fond de l'encoche 244 comme décrit en référence aux figures 1 et 2. Contrairement à la branche 224, la branche 226 ne comporte pas de piste conductrice pour raccorder l'autre extrémité du conducteur 32 à la source 58 de courant.

Les forces de Laplace qui s'exercent sur les jambes 20 et 21, quand le conducteur 32 est parcouru par un courant en présence de la composante $B_y$, sont notées $F_y$ sur la figure 20. Les forces de Laplace qui s'exercent sur les bras 18 et 19, quand le conducteur 32 est parcouru par un courant en présence de la composante $B_x$ du champ magnétique, sont notées $F_x$ sur la figure 20.

Le dispositif 220 comporte également un cadre rigide extérieur suspendu 252 monté en rotation autour de l'axe 246. Ce cadre 252 maintient le cadre 222 suspendu au-dessus du substrat 6. Le cadre 252 comporte deux bras parallèles 254 et 255 à la direction X et deux jambes parallèles 258 et 259 à la direction Y. Ces bras et jambes délimitent un évidement intérieur 262 traversant et rectangulaire.

Chaque bras rigide 254, 255 comporte une branche rigide, respectivement, 264 et 266. Ces branches 264 et 266 s'étendent le long de l'axe 246 en s'éloignant chacune du cadre 252. Les extrémités distales de ces branches 264 et 266 sont mécaniquement reliées à des saillies, respectivement 268 et 269, par l'intermédiaire de barres de torsion, respectivement 272 et 274. Les saillies 268, 269 sont fixées sans aucun degré de liberté sur le substrat 6 ;

Ces barres de torsion 272 et 274 permettent, comme les barres de torsion 38 et 39, de maintenir le cadre 252 suspendu au-dessus du substrat 6 tout en autorisant, essentiellement, seulement un mouvement de rotation du cadre 252 autour de l'axe 246.

La branche 266 est agencée comme la branche 200. Elle comporte donc notamment deux encoches 30 et 202 en vis-à-vis. Des capteurs 276 et 278 sont prévus pour mesurer le débattement angulaire du cadre 252 autour de l'axe 246. Ici, les capteurs 276 et 278 sont identiques, respectivement, aux capteurs 60 et 62. Ils sont agencées en vis-à-vis l'une de l'autre comme décrit en référence à la figure 12.

Le cadre 252 est mécaniquement raccordé au cadre 222 par des barres de torsion 280 et 282 s'étendant le long de l'axe 12. La barre de torsion 280 raccorde mécaniquement directement le milieu de la jambe 258 au milieu du bras 18. La barre de torsion 282 raccorde mécaniquement directement le milieu de la jambe 259 au milieu du bras 19.

Les barres de torsion 280 et 282 permettent de maintenir la cadre 222 suspendu au-dessus du substrat 6 tout en laissant ce cadre 222 libre de se déplacer en rotation autour de l'axe 12.

La structure du cadre 252 et des barres de torsion 280 et 282 est conçue pour amplifier les forces de Laplace Fx grâce à un effet levier des bras 254 et 255. A cet effet, le cadre 252 et les barres 280, 282 sont réalisées comme décrit en référence au cadre 10 et aux barres 38 et 39.

Une piste électrique 286 raccorde l'autre extrémité du conducteur 32, non directement raccordée au plot 42, à un plot de connexion 288 disposé sur l'extrémité supérieure de la saillie 269. Le plot 288 est isolé électriquement de la saillie 269 par une couche 292 en matériau électriquement isolant.

Ici, la piste 286 est déposée successivement sur la barre 282 de torsion, sur la jambe 259, sur le bras 255, sur la branche 266 et sur la barre de torsion 274 avant d'atteindre le plot 288. Dans ce mode de réalisation, la jambe 258 et le bras 254 sont dépourvus de conducteur électrique.

Le déplacement en rotation autour de l'axe 246 du cadre 252 est provoqué par les forces de Laplace Fx qui s'exercent sur le conducteur 2 quand il est parcouru par un courant en présence de la composante $B_x$. Ainsi, un seul et même conducteur électrique, formant une bobine, est utilisé pour mesurer à la fois les composantes $B_x$ et $B_y$ du champ magnétique. Cela permet de réduire notablement la consommation électrique du dispositif 220.

Le dispositif 220 comporte également une unité électronique de traitement 300 raccordée aux différents capteurs du dispositif 220 pour transformer les signaux de ces capteurs en une mesure de l'intensité des composantes $B_x$ et $B_y$.

Le fonctionnement du dispositif 220 est similaire à celui du dispositif 2 et ne sera pas décrit plus en détail. En particulier, on notera que le dispositif 220 amplifie, grâce à un effet levier, aussi bien les forces de Laplace $F_y$ que $F_x$.

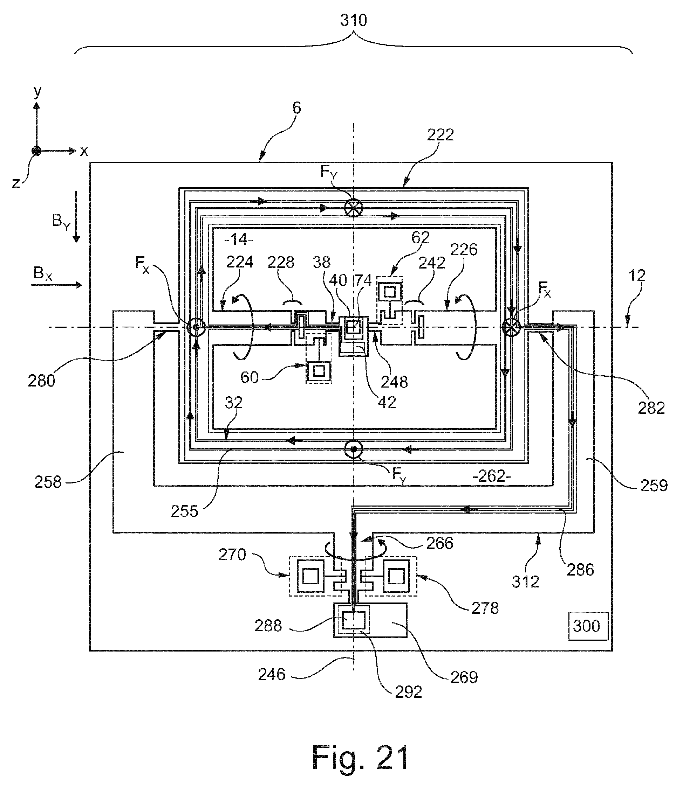

La figure 21 représente un dispositif 310 identique au dispositif 2 sauf que le cadre 252 est remplacé par un cadre rigide 312. Le cadre 312 est identique au cadre 252 sauf que le bras 254 est omis et que la longueur des jambes 258 et 259 est raccourcie. La branche 264, la barre de torsion 272 et la saillie 268 sont également omises.

Ce dispositif 310 fonctionne comme le dispositif 220.

De nombreux autres modes de réalisation sont possibles. Par exemple, comme illustré par les figures 20 et 21, le dispositif de mesure de champ magnétique peut comporter un ou plusieurs axes de mesure. Ainsi, le dispositif de mesure peut être mono-axe ou multiaxes.

Pour augmenter la précision, chacun des dispositifs précédemment décrit peut être enfermé dans un caisson à l'intérieur duquel est réalisé le vide. Cela permet notamment d'accroître le facteur de qualité du système mécanique. Toutefois, selon les applications et la sensibilité souhaitée, cela n'est pas forcément nécessaire.

Quel que soit le mode de réalisation concerné, le conducteur électrique peut ne former qu'une seule spire ou, au contraire, plusieurs spires complètes.

Le courant qui circule dans le conducteur électrique n'est pas nécessairement alternatif. En variante, il s'agit d'un courant variant en fonction du temps de façon non sinusoïdale ou d'un courant continu qui ne change jamais de signe.

De même, il n'est pas nécessaire que les capteurs qui mesurent l'amplitude du débattement angulaire du levier soient montés en différentiel. Ainsi, dans une variante simplifiée, le dispositif ne comporte qu'un seul capteur pour mesurer le débattement angulaire du levier.

L'ohmmètre peut être remplacé par tout moyen de mesure d'une résistance électrique comme par exemple un pont de Wheatstone.

Lorsqu'un capteur à jauge résonnante est utilisé, une seule et même électrode peut être utilisée à la fois pour faire résonner la poutre et pour mesurer la fréquence de vibration de cette poutre.

Le capacimètre peut être remplacé par tout moyen de mesure de la fréquence de vibration de la poutre de la jauge résonnante.

En variante, les axes 12 et 246 ne sont pas perpendiculaires entre eux. Par contre, ces deux axes ne sont pas non plus parallèles entre eux.

Le cadre rigide extérieur 252 peut comporter un conducteur électrique enroulé autour de son évidement central 262. Dans ce cas, de préférence, ce conducteur est raccordé en série avec le conducteur électrique 32 et remplace la piste 286.

Le conducteur électrique 32 peut être alimenté par l'intermédiaire de la barre de torsion 248 même dans le cas où il comporte le cadre extérieur 252. Dans ce cas, la piste électrique 286 est omise.

Le débattement angulaire du cadre 10, 222 ou 252 peut être mesuré par d'autres moyens qu'un capteur comportant une poutre suspendue. Par exemple, le débattement angulaire est mesuré par un capteur capacitif comme décrit dans l'article A2 suivant :

> J. KYYNPÄRPÄINEN, « A 3D micromechanical compass », Sensors and Actuators A, volume 142, pages 561 à 568, 2008.

Le capteur 152 à jauge résonnante décrit en regard de la figure 11 peut être utilisé dans tous les autres modes de la réalisation précédemment décrits à la place d'un capteur à jauge de contrainte.

De nombreux autres modes de réalisation des charnières sont possibles. Par exemple, une barre de torsion peut être réalisée comme décrite dans la demande de brevet déposée en 2011 sous le numéro FR1161487. Une charnière peut aussi être réalisée sans utiliser de barre de torsion. Par exemple, deux lamelles horizontales flexibles dans la direction Z et disposées en vis-à-vis de part et d'autre de l'axe de rotation peuvent être utilisées pour réaliser une charnière.

Dans un autre mode de réalisation, l'épaisseur $e_{38}$ de la barre de torsion 38 est au moins deux ou cinq ou dix fois inférieure, dans la direction Z, à l'épaisseur $e_{CR}$ de la branche 24.

De préférence, le fond des encoches, tel que l'encoche 28, est contenu dans le plan perpendiculaire au plan du cadre et passant par l'axe de rotation de ce cadre.

Comme décrit en regard de la figure 21, dans tous les modes de réalisation précédemment décrit, le cadre mobile peut être suspendu au-dessus du substrat par l'intermédiaire d'une seule charnière.

Des masselottes peuvent être ajoutées sur le cadre mobile de manière à éloigner son centre de gravité de l'axe 12. En faisant cela, on rend le cadre mobile également sensible aux accélérations. Ensuite, l'unité de traitement est programmée pour éliminer du signal de mesure toutes les composantes de fréquence inférieures à, par exemple, 1000 Hz. Le signal ainsi filtré est alors utilisé pour déterminer l'intensité de la composante du champ magnétique mesuré. Le même signal peut également être filtré, en parallèle, pour éliminer toutes les composantes de fréquence supérieures à 1000 Hz. Ce signal filtré est alors utilisé pour mesurer l'accélération subie par le cadre mobile. La masselotte peut être une excroissance de matière dans la direction Y, sur l'une des jambes du cadre. Dans ce cas, on rend le cadre sensible aux accélérations parallèles à la direction Z. La masselotte peut également être une excroissance de matière située dans le plan perpendiculaire au plan du cadre passant par l'axe 12. Dans ce cas, on rend le cadre sensible aux accélérations selon la direction Y.

Si le conducteur ne forme qu'une seule spire, l'évidement au centre du cadre peut être omis.

Dans une autre variante, la poutre du capteur de contrainte s'étend parallèlement à la direction Z entre une extrémité ancrée dans le substrat 6 et une autre extrémité directement ancrée dans la face inférieure d'un des bras du cadre mobile.

## Revendications

1. Dispositif de mesure de champ magnétique à force de Laplace, ce dispositif comportant :

    - un substrat (6) s'étendant essentiellement dans un plan appelé « plan du substrat »,
    - un premier cadre rigide (10 ; 222) s'étendant essentiellement dans un plan appelé « plan du premier cadre » et suspendu au-dessus du substrat, ce premier cadre étant déplaçable par rapport au substrat en rotation autour d'un premier axe (12) de rotation parallèle au plan du substrat, et le premier cadre rigide comportant un évidement central (14) traversant,
    - un conducteur électrique (32) fixé sans aucun degré de liberté sur le premier cadre rigide et comportant une première et une seconde extrémités, ce conducteur étant enroulé, entre sa première et sa seconde extrémités, autour d'un axe (34) d'enroulement perpendiculaire au plan du premier cadre,
    - au moins une première charnière (38) raccordant mécaniquement le premier cadre rigide au substrat, cette charnière comportant une première piste électrique (46) raccordant électriquement la première extrémité du conducteur électrique et un premier plot (42 ; 192) de connexion solidaire du substrat,
- une seconde charnière (39 ; 248) mécaniquement raccordée au premier cadre rigide et comportant une seconde piste électrique (46) raccordant électriquement la seconde extrémité du conducteur électrique à un second plot (52) de connexion solidaire du substrat, et
- au moins un premier capteur (60, 62 ; 152, 154) apte à mesurer une grandeur physique représentative de l'amplitude du débattement angulaire du premier cadre rigide autour de son axe de rotation,

**caractérisé en ce que** :

- la première charnière (38) et sa première piste (46) sont situés à l'intérieur de l'évidement central (14) du premier cadre rigide, et
- la seconde charnière (39 ; 248) et sa seconde piste (46) sont situés à l'extérieur de l'évidement central (14) du premier cadre rigide.

2. Dispositif selon la revendication 1, dans lequel le premier capteur (60, 62 ; 152, 154) est un capteur de contrainte et ce capteur comporte une poutre (64, 80 ; 160) dont une première extrémité est ancrée directement dans le premier cadre rigide et dont une seconde extrémité est ancrée, sans aucun degré de liberté, sur le substrat, la première extrémité étant ancrée dans le premier cadre rigide à une distance $d_p$ non nulle du premier axe de rotation, cette distance $d_p$ étant au moins deux fois plus petite que l'épaisseur du premier cadre et l'épaisseur de cette poutre étant au moins deux fois inférieure à l'épaisseur du premier cadre rigide.

3. Dispositif selon la revendication 2, dans lequel la poutre est entièrement disposée en-dessous d'un plan parallèle au plan du substrat et passant par l'axe de rotation.

4. Dispositif selon l'une quelconque des revendications précédentes, dans lequel le centre de gravité du premier cadre rigide (10 ; 222) est contenu dans un plan perpendiculaire au plan du premier cadre et contenant le premier axe de rotation.

5. Dispositif selon l'une quelconque des revendications 2 à 4, dans lequel le premier cadre rigide comprend au moins une branche latérale rigide (24, 26 ; 200 ; 224, 226) s'étendant le long du premier axe de rotation, et la poutre (64, 80 ; 160) est une poutre suspendue au-dessus du substrat, cette poutre s'étend perpendiculairement au premier axe de rotation essentiellement dans un plan parallèle au plan du substrat et sa première extrémité étant :

- située strictement au-dessus ou strictement en-dessous d'un plan passant par le premier axe de rotation et parallèle au plan du substrat, et
- directement fixée sur la branche latérale.

6. Dispositif selon la revendication 5, dans lequel la branche latérale comporte une encoche (28, 30 ; 30, 202 ; 28, 244) s'étendant perpendiculairement au premier axe de rotation jusqu'à un fond et la première extrémité de la poutre est directement fixée sans aucun degré de liberté sur ce fond.

7. Dispositif selon l'une quelconque des revendications précédentes, dans lequel le premier cadre rigide comporte un premier et un second bras rigides (18, 19) parallèles situés de part et d'autre de l'évidement central (14) traversant du premier cadre rigide, et la seconde charnière (39) raccorde mécaniquement le premier cadre rigide au substrat, les première et seconde charnières étant mécaniquement raccordées directement, respectivement, au premier et au second bras.

8. Dispositif selon l'une quelconque des revendications précédentes, dans lequel le premier plot (192) de connexion est situé à l'extérieur du premier cadre rigide et le dispositif comprend une piste électrique (198), passant sous le premier cadre rigide et reliant électriquement la première piste électrique (46) de la première charnière (38) à ce plot (192) de connexion solidaire du substrat situé à l'extérieur du cadre rigide.

9. Dispositif selon l'une quelconque des revendications précédentes, dans lequel le dispositif comporte :

- un second cadre rigide (252; 312) s'étendant essentiellement dans un plan et suspendu au-dessus du substrat, ce second cadre étant déplaçable par rapport au substrat en rotation autour d'un second axe (246) de rotation parallèle au plan du substrat et non parallèle au premier axe (12) de rotation, ce second cadre rigide comportant un évidement central (262) à l'intérieur duquel est reçu le premier cadre rigide,
- au moins une troisième charnière (272, 274) raccordant mécaniquement le second cadre rigide au substrat,
- au moins un second capteur (276, 278) apte à mesurer une grandeur physique représentative de l'amplitude du débattement angulaire du second cadre rigide autour du second axe de rotation, et
- la seconde charnière (282) est suspendue au-dessus du substrat fixée, d'un côté, sur le premier cadre rigide et, d'un côté opposé, sur le second cadre rigide, cette seconde charnière suspendue étant conformée pour autoriser la rotation du premier cadre rigide autour du premier axe de rotation et maintenir ce premier cadre rigide suspendu au-dessus du substrat.

**10.** Dispositif selon l'une quelconque des revendications précédentes, dans lequel l'axe d'enroulement traverse l'évidement central..

**11.** Dispositif selon l'une quelconque des revendications précédentes, dans lequel chaque charnière permettant la rotation d'un cadre rigide autour de son axe de rotation comprend une barre de torsion qui s'étend le long de cet axe de rotation, cette barre de torsion étant conformée de manière à se déformer essentiellement en torsion lors de la rotation de ce cadre rigide.

**12.** Dispositif selon l'une quelconque des revendications précédentes, dans lequel le conducteur électrique (32) s'enroule plusieurs fois autour du premier axe d'enroulement pour former une bobine à plusieurs spires.

**13.** Dispositif selon la revendication 2, dans lequel la poutre (64, 80) du capteur est réalisée en matériau piézorésistif et le capteur comporte des moyens aptent à mesurer une grandeur physique représentative de la variation de la résistance de la poutre en réponse à la rotation du cadre rigide.

**14.** Dispositif selon la revendication 2, dans lequel le capteur comporte :

- une électrode (168) apte à faire vibrer la poutre (160),
- une autre électrode (176) ou la même électrode pour mesurer la vibration de la poutre,
- des moyens (178) aptent à mesurer une grandeur physique représentative de la fréquence de vibration de la poutre, et
- une source d'alimentation de l'électrode apte à asservir la fréquence de vibration de la poutre sur la fréquence de résonance mécanique de cette poutre.

**Patentansprüche**

**1.** Vorrichtung zur Messung eines Magnetfeldes mit Laplace-Kraft, wobei diese Vorrichtung umfasst:

- ein Substrat (6), das sich im Wesentlichen in einer Ebene erstreckt, "Substratebene" genannt,
- einen ersten starren Rahmen (10; 222), der sich im Wesentlichen in einer Ebene erstreckt, "Ebene des ersten Rahmens" genannt, und der über dem Substrat aufgehängt ist, wobei dieser erste Rahmen in Bezug zu dem Substrat in Drehung um eine erste Achse (12) mit einer Drehung parallel zu der Ebene des Substrats verschiebbar ist, wobei der erste starre Rahmen eine durchgehende zentrale Ausnehmung (14) umfasst,
- einen elektrischen Leiter (32), der ohne Freiheitsgrad auf dem ersten starren Rahmen befestigt ist und ein erstes und ein zweites Ende umfasst, wobei dieser Leiter zwischen seinem ersten und seinem zweiten Ende um eine Wickelachse (34) senkrecht zu der Ebene des ersten Rahmens gewickelt ist,
- mindestens ein erstes Scharnier (38), das den ersten starren Rahmen mechanisch an das Substrat anschließt, wobei dieses Scharnier eine erste elektrische Spur (46) umfasst, die das erste Ende des elektrischen Leiters an ein erstes Kontaktstück (42; 192), das mit dem Substrat verbunden ist, anschließt;
- ein zweites Scharnier (39; 248), das mechanisch an den ersten starren Rahmen angeschlossen ist und eine zweite elektrische Spur (46) umfasst, die das zweite Ende des elektrischen Leiters an ein zweites Kontaktstück (52), das mit dem Substrat verbunden ist, anschließt, und
- mindestens einen ersten Sensor (60, 62; 152, 154), der geeignet ist, eine physikalische Größe, die für die Amplitude des Winkelausschlags des ersten starren Rahmens um seine Drehachse repräsentativ ist, zu messen,

**dadurch gekennzeichnet, dass**:

- das erste Scharnier (38) und seine erste Spur (46) im Inneren der zentralen Ausnehmung (14) des ersten starren Rahmens angeordnet sind, und
- das zweite Scharnier (39; 248) und seine zweite Spur (46) außerhalb der zentralen Ausnehmung (14) des ersten starren Rahmens angeordnet sind.

**2.** Vorrichtung nach Anspruch 1, bei der der erste Sensor (60, 62; 152, 154) ein Spannungssensor ist, und dieser Sensor einen Träger (64, 80; 160) umfasst, dessen erstes Ende direkt in dem ersten starren Rahmen verankert ist, und dessen zweites Ende ohne Freiheitsgrad auf dem Substrat verankert ist, wobei das erste Ende in dem ersten starren Rahmen in einem Abstand $d_p$ ungleich Null zu der ersten Drehachse verankert ist, wobei dieser Abstand $d_p$ mindestens zweimal kleiner als die Dicke des ersten Rahmens ist, und die Dicke dieses Trägers mindestens zweimal kleiner als die Dicke des ersten starren Rahmens ist.

**3.** Vorrichtung nach Anspruch 2, bei der der Träger zur Gänze unter einer Ebene parallel zur Ebene des Substrats und durch die Drehachse verlaufend angeordnet ist.

4. Vorrichtung nach einem der vorhergehenden Ansprüche, bei der der Schwerpunkt des ersten starren Rahmens (10; 222) in einer Ebene senkrecht zur des ersten Rahmens, die die erste Drehachse enthält, enthalten ist.

5. Vorrichtung nach einem der Ansprüche 2 bis 4, bei der der erste starre Rahmen mindestens einen starren Seitenschenkel (24, 26; 200; 224, 226) umfasst, der sich entlang der ersten Drehachse erstreckt, und der Träger (64, 80; 160) ein über dem Substrat hängender Träger ist, wobei sich dieser Träger senkrecht zur ersten Drehachse im Wesentlichen in einer Ebene parallel zur Ebene des Substrats erstreckt, und wobei sein erstes Ende:

   - genau über oder genau unter einer Ebene angeordnet ist, die durch die erste Drehachse verläuft und zur Ebene des Substrats parallel ist, und
   - direkt auf dem Seitenschenkel befestigt ist.

6. Vorrichtung nach Anspruch 5, bei der der Seitenschenkel eine Kerbe (28, 30; 30, 202; 28, 244) umfasst, die sich senkrecht zur ersten Drehachse bis zu einem Boden erstreckt, und das erste Ende des Trägers direkt ohne Freiheitsgrad auf diesem Boden befestigt ist.

7. Vorrichtung nach einem der vorhergehenden Ansprüche, bei der der erste starre Rahmen einen ersten und einen zweiten starren Arm (18, 19) umfasst, die parallel sind und sich beiderseits der zentralen Ausnehmung (14) befinden, die durch den ersten starren Rahmen hindurchgeht, und das zweite Scharnier (39) mechanisch den ersten starren Rahmen an das Substrat anschließt, wobei die ersten und zweiten Scharniere mechanisch direkt an den ersten bzw. zweiten Arm angeschlossen sind.

8. Vorrichtung nach einem der vorhergehenden Ansprüche, bei der das erste Kontaktstück (192) außerhalb des ersten starren Rahmens angeordnet ist, und die Vorrichtung eine elektrische Spur (198) umfasst, die unter dem ersten starren Rahmen verläuft und die erste elektrische Spur (46) des ersten Scharniers (38) elektrisch mit diesem Kontaktstück (192) verbindet, das mit dem Substrat verbunden ist, das sich außerhalb des starren Rahmens befindet.

9. Vorrichtung nach einem der vorhergehenden Ansprüche, wobei die Vorrichtung umfasst:

   - einen zweiten starren Rahmen (252; 312), der sich im Wesentlichen in einer Ebene erstreckt und über dem Substrat hängt, wobei dieser zweite Rahmen in Bezug zu dem Substrat in Drehung um eine zweite Drehachse (246) parallel zur Ebene des Substrats und nicht parallel zur ersten Drehachse (12) verschiebbar ist, wobei dieser zweite starre Rahmen eine zentrale Ausnehmung (262) umfasst, in der der erste starre Rahmen aufgenommen ist,
   - mindestens ein drittes Scharnier (272, 274), das mechanisch den zweiten starren Rahmen an das Substrat anschließt,
   - mindestens einen zweiten Sensor (276, 278), der geeignet ist, eine physikalische Größe, die für die Amplitude des Winkelausschlags des zweiten starren Rahmens um die zweite Drehachse repräsentativ ist, zu messen, und
   - wobei das zweite Scharnier (282) über dem Substrat hängt und einerseits auf dem ersten starren Rahmen und auf einer gegenüberliegenden Seite auf dem zweiten starren Rahmen befestigt ist, wobei dieses zweite hängende Scharnier derart ausgeführt ist, dass es die Drehung des ersten starren Rahmens um die erste Drehachse gestattet und diesen ersten starren Rahmen über dem Substrat hängend hält.

10. Vorrichtung nach einem der vorhergehenden Ansprüche, bei der die Wickelachse durch die zentrale Ausnehmung hindurchgeht.

11. Vorrichtung nach einem der vorhergehenden Ansprüche, bei der jedes Scharnier, das die Drehung eines starren Rahmens um seine Drehachse ermöglicht, einen Torsionsstab umfasst, der sich entlang dieser Drehachse erstreckt, wobei dieser Torsionsstab derart ausgeführt ist, dass er sich im Wesentlichen bei der Drehung dieses starren Rahmens in Torsion verformt.

12. Vorrichtung nach einem der vorhergehenden Ansprüche, bei der sich der elektrische Leiter (32) mehrmals um die erste Wickelachse wickelt, um eine Spule mit mehreren Windungen zu bilden.

13. Vorrichtung nach Anspruch 2, bei der der Träger (64, 80) des Sensors aus einem piezoresistiven Material hergestellt ist, und der Sensor Mittel umfasst, die geeignet sind, eine physikalische Größe zu messen, die für die Variation des Widerstands des Trägers als Reaktion auf die Drehung des starren Rahmens repräsentativ ist.

14. Vorrichtung nach Anspruch 2, bei der der Sensor umfasst:

   - eine Elektrode (168), die geeignet ist, den Träger (160) vibrieren zu lassen,

- eine weitere Elektrode (176) oder dieselbe Elektrode, um die Vibration des Trägers zu messen,
- Mittel (178), die geeignet sind, eine physikalische Größe zu messen, die für die Vibrationsfrequenz des Trägers repräsentativ ist,
- eine Versorgungsquelle der Elektrode, die geeignet ist, die Vibrationsfrequenz des Trägers auf die mechanische Resonanzfrequenz dieses Trägers einzustellen.

**Claims**

1. Device for measuring a magnetic field with Laplace force, this device comprising:

   - a substrate (6) extending essentially in a plane called "plane of the substrate",
   - a first rigid frame (10; 222) extending essentially in a plane called "plane of the first frame" and suspended above the substrate, this first frame being able to be displaced relative to the substrate in rotation about a first axis (12) of rotation parallel to the plane of the substrate, and the first rigid frame comprising a through central void (14),
   - an electrical conductor (32) fixed with no degree of freedom onto the first rigid frame and comprising a first and a second ends, this conductor being wound, between its first and its second ends, around a winding axis (34) at right angles to the plane of the first frame,
   - at least one first hinge (38) mechanically connecting the first rigid frame to the substrate, this hinge comprising a first electrical track (46) electrically connecting the first end of the electrical conductor and a first contact pad (42; 192) secured to the substrate,
   - a second hinge (39; 248) mechanically connected to the first rigid frame and comprising a second electrical track (46) electrically connecting the second end of the electrical conductor to a second contact pad (52) secured to the substrate, and
   - at least one first sensor (60, 62; 152, 154) capable of measuring a physical quantity representative of the amplitude of the angular displacement of the first rigid frame about its axis of rotation,

   **characterized in that**:

   - the first hinge (38) and its first track (46) are situated inside the central void (14) of the first rigid frame, and
   - the second hinge (39; 248) and its second track (46) are situated outside the central void (14) of the first rigid frame.

2. Device according to Claim 1, in which the first sensor (60, 62; 152, 154) is a strain sensor and this sensor comprises a beam (64, 80; 160), a first end of which is anchored directly in the first rigid frame and a second end of which is anchored, with no degree of freedom, on the substrate, the first end being anchored in the first rigid frame at a non-zero distance $d_p$ from the first axis of rotation, this distance $d_p$ being at least two times smaller than the thickness of the first frame and the thickness of this beam being at least two times less than the thickness of the first rigid frame.

3. Device according to Claim 2, in which the beam is entirely arranged under a plane parallel to the plane of the substrate and passing through the axis of rotation.

4. Device according to any one of the preceding claims, in which the centre of gravity of the first rigid frame (10; 222) is contained in a plane at right angles to the plane of the first frame and containing the first axis of rotation.

5. Device according to any one of Claims 2 to 4, in which the first rigid frame comprises at least one rigid lateral branch (24, 26; 200; 224, 226) extending along the first axis of rotation, and the beam (64, 80; 160) is a beam suspended above the substrate, this beam extending at right angles to the first axis of rotation essentially in a plane parallel to the plane of the substrate and its first end being:

   - situated strictly above or strictly below a plane passing through the first axis of rotation and parallel to the plane of the substrate, and
   - directly fixed onto the lateral branch.

6. Device according to Claim 5, in which the lateral branch comprises a notch (28, 30; 30, 202; 28, 244) extending at right angles to the first axis of rotation to a bottom and the first end of the beam is directly fixed with no degree of freedom onto this bottom.

7. Device according to any one of the preceding claims, in which the first rigid frame comprises a first and a second parallel rigid arms (18, 19) situated on either side of the through central void (14) of the first rigid frame, and the second hinge (39) mechanically connects the first rigid frame to the substrate, the first and second hinges being mechanically connected directly, respectively, to the first and to the second arms.

8. Device according to any one of the preceding claims, in which the first contact pad (192) is situated outside the first rigid frame and the device comprises an electrical track (198), passing under the first rigid frame and electrically linking the first electrical track (46) of the first hinge (38) to this contact pad (192) secured to the substrate situated outside of the rigid frame.

9. Device according to any one of the preceding claims, in which the device comprises:

- a second rigid frame (252; 312) extending essentially in a plane and suspended above the substrate, this second frame being able to be displaced relative to the substrate in rotation about a second axis (246) of rotation parallel to the plane of the substrate and not parallel to the first axis (12) of rotation, this second rigid frame comprising a central void (262) inside which the first rigid frame is received,
- at least one third hinge (272, 274) mechanically connecting the second rigid frame to the substrate,
- at least one second sensor (276, 278) capable of measuring a physical quantity representative of the amplitude of the angular displacement of the second rigid frame about the second axis of rotation, and
- the second hinge (282) is suspended above the substrate and fixed, on one side, on the first rigid frame and, on an opposite side, on the second rigid frame, this suspended second hinge being configured to allow the rotation of the first rigid frame about the first axis of rotation and keep this first rigid frame suspended above the substrate.

10. Device according to any one of the preceding claims, in which the winding axis passes through the central void.

11. Device according to any one of the preceding claims, in which each hinge allowing the rotation of a rigid frame about its axis of rotation comprises a torsion bar which extends along this axis of rotation, this torsion bar being configured so as to be deformed essentially in torsion upon the rotation of this rigid frame.

12. Device according to any one of the preceding claims, in which the electrical conductor (32) is wound a number of times about the first winding axis to form a coil with a number of turns.

13. Device according to Claim 2, in which the beam (64, 80) of the sensor is made of piezoresistive material and the sensor comprises means capable of measuring a physical quantity representative of the variation of the resistance of the beam in response to the rotation of the rigid frame.

14. Device according to Claim 2, in which the sensor comprises:

- an electrode (168) capable of making the beam (160) vibrate,
- another electrode (176) or the same electrode for measuring the vibration of the beam,
- means (178) capable of measuring a physical quantity representative of the frequency of vibration of the beam, and
- an electrode power source capable of locking the frequency of vibration of the beam onto the mechanical resonance frequency of this beam.

Fig. 1

Fig. 2

EP 2 890 992 B1

Fig. 3

124   126   122
120
6

Fig. 4

124   128   122
120
6

Fig. 5

130
120
6

Fig. 6

132
130
120
6

Fig. 7

134   134  134  134
132
130
120
6

Fig. 8

134   134   134
132
130
120
6

Fig. 9

74   46   32   36
64
40   24   10   6

Fig. 10

Fig. 11

Fig. 12

Fig. 13

Fig. 14

Fig. 15

Fig. 16

Fig. 17

Fig. 18

Fig. 19

Fig. 20

Fig. 21

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2011304325 A1
- US 7642692 B1
- US 2006076947 A1
- FR 1161487

**Littérature non-brevet citée dans la description**

- **A.L. HERRERA-MAY et al.** A resonant magnetic field microsensor with high quality factor at atmospheric pressure. *J. Micromechanical Microengineering,* 2009, vol. 19, 015016
- **J. KYYNPÄRPÄINEN.** A 3D micromechanical compass. *Sensors and Actuators A,* 2008, vol. 142, 561-568